# EUROPEAN PATENT APPLICATION

(11) **EP 2 166 566 A1**
(43) Date of publication of application: **24.03.2010**
(21) Application number: 07790472.0
(22) Date of filing: 09.07.2007
(51) Int. Cl.: H01L 21/673

(54) **DEVICE FOR CHARGING DRY AIR OR NITROGEN GAS INTO SEMICONDUCTOR WAFER STORAGE CONTAINER AND WAFER STATIC CHARGE REMOVING APPARATUS UTILIZING THE DEVICE**

(71) Applicant: Kondoh Industries Ltd., Tokyo 105-0001 (JP); Cambridge Filter Japan, Ltd., Tokyo 105-0001 (JP)
(72) Inventor: KISAKIBARU, Toshirou, Tokyo 105-0001 (JP); OKADA, Makoto, Tokyo 105-0001 (JP); IIDA, Naoji, Tokyo 105-0001 (JP); HONDA, Yasushi, Tokyo 105-0001 (JP)
(74) Representative: Thum, Bernhard
(86) International application number: PCT/JP2007/063651
(87) International publication number: WO 2009/008047

(57) **Abstract**

An apparatus for charging dry air or nitrogen gas into a container for storing semiconductor wafers can remove chemical gas and moisture from the container, and then prevent acid from being generated at the surfaces of the wafers.

The apparatus A for charging dry air or nitrogen gas into a container 1 for storing semiconductor wafers 9 is connected to an opening 8a, acting as an intake, and to an opening 8b, acting as an exhaust, wherein the container 1 comprises a plurality of openings 8 disposed at the bottom plate of the container 1, the apparatus comprising:
PTFE filters 7 disposed at the plurality of openings 8a, 8b,
a portion 11 for providing the dry air or nitrogen gas to the container 1, and
a portion 12 for exhausting the used dry air or nitrogen gas from the container 1 after removing chemical gas and moisture from the container, and then preventing acid from being generated at the surfaces of the wafers 9.

## Description

### Technical Field

This invention relates to an apparatus for charging dry air or nitrogen gas into a container for storing semiconductor wafers and an apparatus for removing static electricity from the surfaces of the wafers by using the apparatus for charging dry air or nitrogen gas. The container is used for storing semiconductor wafers that are used for producing semiconductor chips. Since any chemical gas or moisture present in the container can be removed by charging dry air or nitrogen gas into the container, it is possible to prevent an acid from being generated at the surfaces of the wafers.

### Background of the Invention

Conventionally, for processes for producing semiconductor chips in a clean room using a minienvironment system, since miniaturization of the circuits of the semiconductor chips had been developed, the processes have become complicated. Particularly, for a process for etching semiconductor wafers by using halogen gases, since an acid is generated by a chemical reaction of the moisture in dry air and the halogen gases that remain after the etching process, it becomes a serious problem in that the acid corrodes the semiconductor wafers. To prevent the corrosion of the semiconductor wafers, acid is prevented from being generated, by charging dry air or nitrogen gas into a container of semiconductor wafers after storing those that have been already processed, in the container.

For the processes for producing semiconductor chips in a clean room using the minienvironment system, the semiconductor wafers are stored in the container, and then are transported and are thus ready for the next step. When the semiconductor wafers are inserted into the container, or while the container with the wafers is transported, since the wafers are charged with static electricity, an electrostatic breakdown of the semiconductor circuits is caused. Further, problems occur that are caused by dust that is attached to the surfaces of the semiconductor wafers due to the static electricity. Conventionally, as a countermeasure against these problems, the amount of the static electricity is reduced by imparting electrical conductivity to the material of which the container is made by mixing a powder of carbon with the material.

The inventors of the present inventions searched patent documents regarding the following apparatuses:
- an apparatus for charging dry air or nitrogen gas into a container for storing semiconductor wafers without opening the lid of the container, to remove chemical gas and moisture from the container, and then to prevent the corrosion of the semiconductor wafers by preventing acid from being generated at the surfaces of the wafers, and
- an apparatus for removing static electricity from the surfaces of the wafers by using the apparatus for charging ionized dry air or nitrogen gas, to remove chemical gas and moisture from the container, then to remove the charged static electricity from the wafers, and further to prevent the corrosion of the wafers by preventing acid from being generated at the surfaces of the wafers, which apparatus for removing static electricity is attached to the container.
However they were able to find no patent document that disclosed such apparatuses.

### Disclosure of Invention

As described above, for the conventional processes, to prevent the corrosion of the wafers by preventing acid that is generated by a chemical reaction of moisture and halogen gases from being generated at the surfaces of the semiconductor wafers, dry air or nitrogen gas that contains little moisture is charged into the container for storing semiconductor wafers. To maintain an efficient production, the dry air or nitrogen gas must be quickly charged into the container. Further, when the semiconductor wafers are stored in the container, since the undersides of the wafers contact the surface of an arm of a robot, a small amount of dust is generated. The dust is likely to enter the container. Thus, there is a problem in that the dust that is caused by the above reason and by any other reason accumulates at the bottom of the container.

When the dry air or nitrogen gas is charged into the container for storing the semiconductor wafers, since at the initial stage for charging dry air or nitrogen gas the pressure in the container is nearly equal to atmospheric pressure, the dry air or nitrogen gas is charged into the container through its intake port at a high flow rate. As the pressure in the container increases, the flow rate of the dry air or nitrogen gas decreases. At the initial stage for charging dry air or nitrogen gas, there is a problem in that the dust that has accumulated at the bottom of the container or that is attached to the undersides of the wafers is stirred up, since the dry air or nitrogen gas is charged into the container at a high flow rate, and then the dust is attached to the circuits of the semiconductor at the upper surfaces of the wafers.

It is possible to apply a method for controlling the flow rate of the dry air or nitrogen gas for charging it into the container for storing the semiconductor wafers by using a mass flow meter. However, even if a mass flow meter is provided in the apparatus, the surge of the flow of the dry air or nitrogen gas cannot be avoided. Further, since a mass flow meter is very expensive, there is a problem in that the cost of the apparatus increases.

On the other hand, the miniaturization of the circuits of semiconductor chips has developed, and in the processes for producing semiconductor chips, the size of the particles of contaminating dust to be controlled has become at the nanometer level. However, the breakdown of the semiconductor circuits due to a small amount of the static electricity remaining and the attachment of the dust to the semiconductor wafers is caused. The method for imparting electrical conductivity to the material of which the container is made by mixing a conductive material, such as a powder of carbon, with the material, cannot entirely prevent generating the static electricity toward the semiconductor wafers. Disadvantageously, as the amount of the carbon in the material composing the container increases, the chemical gases generated from that material become a problem. Thus, the problems of the static electricity affecting the semiconductor wafers cannot be entirely solved.

When the semiconductor wafers are stored in such a container, some semiconductor industries try to charge ionized air into the container through its open port, and then the open port is closed by a lid. However, a favorable outcome cannot be obtained.

The present inventions are intended to overcome the problems explained in the above paragraphs. Namely, the present inventions are intended to provide the following apparatuses:
- an apparatus for charging dry air or nitrogen gas into a container for storing semiconductor wafers without opening the lid of the container, to remove chemical gas and moisture from the container, and then to prevent the corrosion of the semiconductor wafers by preventing acid from being generated at the surfaces of the wafers, and
- an apparatus for removing static electricity from the surfaces of the wafers by using the above apparatus for charging ionized dry air or nitrogen gas, to prevent the dust that has accumulated at the bottom of the container from being stirred up, to remove the charged static electricity from the wafers, and to remove the moisture from the container, and further to prevent the corrosion of the wafers by preventing acid from being generated at the surfaces of the wafers.

To overcome the problems explained in the above paragraphs, for a first aspect of the present inventions it is intended to provide the following apparatus. It is constituted as follows:
an apparatus for charging dry air or nitrogen gas into a container for storing semiconductor wafers, wherein the container comprises a plurality of openings disposed at the bottom plate of the container, and wherein the apparatus for charging dry air or nitrogen gas is connected to the opening for an intake and to the opening for an exhaust, the apparatus comprising:
   PTFE filters disposed at the plurality of openings,
a portion for providing the dry air or nitrogen gas to charge the dry air or nitrogen gas into the container, and
a portion for exhausting the used dry air or nitrogen gas to discharge the used dry air or nitrogen gas from the container after removing any chemical gas and moisture from the container, and then preventing acid from being generated at the surfaces of the wafers by the dry air or nitrogen gas that is charged into the container,
wherein the portion for providing the dry air or nitrogen gas is connected to a hollow vessel that has a nozzle for providing it and is disposed at the side of the intake of the container, and the nozzle for providing it is hermetically fixed to the opening for the intake,
wherein the portion for exhausting the used dry air or nitrogen gas is connected to a hollow vessel that has an exhaust nozzle and an exhaust port for discharging the used dry air or nitrogen gas and is disposed at the side of the exhaust port of the container, and the exhaust nozzle is hermetically fixed to the opening for the exhaust,
wherein the dry air or nitrogen gas that is provided for the hollow vessel disposed at the side of the intake of the container is filtered by removing dust by means of the PTFE filter and flows into the container, and then removes any chemical gas and moisture from the container, and prevents acid from being generated at the surfaces of the wafers, and
wherein the used dry air or nitrogen gas is discharged into the hollow vessel disposed at the side of the exhaust through the PTFE filter disposed at the opening for the exhaust, and then is exhausted through the exhaust port of the hollow vessel disposed at the side of the exhaust.

For a second aspect of the present inventions,
the apparatus for charging dry air or nitrogen gas into a container for storing semiconductor wafers further comprises a buffering tank disposed on the pathway for providing the dry air or nitrogen gas of the portion for providing the dry air or nitrogen gas.

For a third aspect of the present inventions,
the buffering tank of the apparatus for charging dry air or nitrogen gas into a container for storing semiconductor wafers comprises a hollow vessel.

For a fourth aspect of the present inventions,
the buffering tank of the apparatus for charging dry air or nitrogen gas into a container for storing semiconductor wafers further comprises a filter or a plurality of filters disposed at predetermined intervals in the buffering tank.

For a fifth aspect of the present inventions,
the buffering tank of the apparatus for charging dry air or nitrogen gas into a container for storing semiconductor wafers further comprises a perforated plate or a plurality of perforated plates disposed at predetermined intervals in the buffering tank.

For a sixth aspect of the present inventions, it is intended to provide the following apparatus, which is constituted as follows:
an apparatus for removing static electricity by using the apparatus for charging dry air or nitrogen gas into a container for storing semiconductor wafers, wherein the container comprises a plurality of openings disposed at the bottom plate of the container, and wherein the apparatus for charging dry air or nitrogen gas is connected to the opening for an intake and to the opening for an exhaust, the apparatus for removing static electricity comprising:
   PTFE filters disposed at the plurality of openings,
a portion for providing the ionized dry air or nitrogen gas to charge the ionized dry air or nitrogen gas into the container, and
a portion for exhausting the used ionized dry air or nitrogen gas to discharge the used ionized dry air or nitrogen gas from the container after removing chemical gas, moisture, and static electricity from the container, and then preventing acid from being generated at the surfaces of the wafers by the ionized dry air or nitrogen gas charged into the container,
wherein the portion for providing the dry ionized air or nitrogen gas is connected to a hollow vessel that has a nozzle for providing it and is disposed at the side of the intake of the container, and the nozzle for providing it is hermetically fixed to the opening for the intake, the hollow vessel being further connected to an ion generator, which ionizes the dry air or nitrogen gas,
wherein the portion for exhausting the used ionized dry air or nitrogen gas is connected to a hollow vessel that has an exhaust nozzle and an exhaust port for discharging the used ionized dry air or nitrogen gas and is disposed at the side of the exhaust port of the container, and the exhaust nozzle is hermetically fixed to the opening for the exhaust,
wherein the dry air or nitrogen gas that is provided for the hollow vessel disposed at the side of the intake of the container becomes the ionized by ionization, and is filtered by removing dust by means of the PTFE filter while the ions are maintained and flows into the container, and then removes the chemical gas, the moisture, and the static electricity from the container, and prevents acid from being generated at the surfaces of the wafers, and
wherein the used ionized dry air or nitrogen gas is discharged into the hollow vessel disposed at the side of the exhaust port through the PTFE filter disposed at the opening for the exhaust, and then is exhausted through the exhaust port of the hollow vessel disposed at the side of the exhaust port.

For a seventh aspect of the present inventions,
the apparatus for removing static electricity further comprises a buffering tank disposed on the pathway for providing the ionized dry air or nitrogen gas of the portion for providing the ionized dry air or nitrogen gas.

For an eighth aspect of the present inventions,
the buffering tank of the apparatus for removing static electricity comprises a hollow vessel.

For a ninth aspect of the present inventions,
the buffering tank of the apparatus for removing static electricity further comprises a filter or a plurality of filters disposed at predetermined intervals in the hollow vessel.

For a tenth aspect of the present inventions,
the buffering tank of the apparatus for removing static electricity further comprises a perforated plate or a plurality of perforated plates disposed at predetermined intervals in the hollow vessel.

By the first aspect of the present inventions,
by charging dry air or nitrogen gas, into a container for storing semiconductor wafers without opening the lid of the container, through the PTFE filter disposed at the opening for the intake of the container, the chemical gas and moisture can be removed from the container, and then the semiconductor wafers can be prevented from corroding by preventing acid from being generated at the surfaces of the wafers.

By the second to fifth aspects of the present inventions,
when the dry air or nitrogen gas is charged into the container for storing the semiconductor wafers from the nozzle for providing it, and until the pressure in the container increases at the initial stage, the dry air or nitrogen gas is charged at a high flow rate. As the pressure in the container increases, the flow rate of the dry air or nitrogen gas decreases. By installing a buffering tank on the pathway for providing the dry air or nitrogen gas of the apparatus, since the flow rate of the dry air or nitrogen gas that is provided to the hollow vessel disposed at the side of the intake of the container is averaged, it is possible to prevent the dry air or nitrogen gas from being rapidly charged into the container. Thus, the dust that has accumulated at the bottom of the container is not stirred up.
By the fourth aspect of the present inventions, as compared with the third aspect of the present inventions, not only can the flow rate of the dry air or nitrogen gas to a high degree be averaged, but the dust generated from the opening and closing valve disposed at the upstream side of the buffering tank can also be removed.
Further, by the fifth aspect of the present inventions, as compared with the third aspect of the present inventions, the flow rate of the dry air or nitrogen gas can to a high degree be averaged.

By the sixth aspect of the present inventions,
by charging ionized dry air or nitrogen gas, into a container for storing semiconductor wafers without opening the lid of the container, through the PTFE filter disposed at the opening for the intake of the container, the dust can be removed, but the ions can be maintained. By the ionized dry air or nitrogen gas being charged into the container, the chemical gas and moisture can be removed from the container, and the semiconductor wafers can be prevented from corroding by preventing acid from being generated at the surfaces of the wafers, and then the static electricity charged on the wafers can be removed.

By the seventh to tenth aspects of the present inventions,
when the ionized dry air or the nitrogen gas is charged into the container for storing the semiconductor wafers from the nozzle for providing it, and until the pressure in the container increases at the initial stage, the ionized dry air or nitrogen gas is charged at a high flow rate. As the pressure in the container increases, the flow rate of the ionized dry air or nitrogen gas decreases. By installing a buffering tank on the pathway for providing the ionized dry air or nitrogen gas of the apparatus, since the flow rate of the ionized dry air or nitrogen gas that is provided to the hollow vessel disposed at the side of the intake of the container is averaged, it is possible to prevent the ionized dry air or nitrogen gas from being rapidly charged into the container. Thus, the dust that has accumulated at the bottom of the container is not stirred up.
By the ninth aspect of the present inventions, as compared with the eighth aspect of the present inventions, not only can the flow rate of the ionized dry air or nitrogen gas be averaged so that the change of the flow rate is reduced, but the dust generated from an opening and closing valve disposed at the upstream side of the buffering tank can also be removed.

Further, by the tenth aspect of the present inventions, as compared with the eighth aspect of the present inventions, the flow rate of the ionized dry air or nitrogen gas can to a high degree be averaged.

### Brief Descriptions of the Drawings

Fig. 1 shows a vertical and sectional view of the container for storing semiconductor wafers that is used for the apparatus of this invention for charging dry air or nitrogen gas into a container for storing semiconductor wafers.
Fig. 2 shows a bottom plane view of the container.
Fig. 3 shows a plane view of the apparatus of this invention for charging dry air or nitrogen gas into the container for storing semiconductor wafers.
Fig. 4 shows a vertical and sectional view of the apparatus of this invention for charging dry air or nitrogen gas that is attached to the container for storing semiconductor wafers.
Fig. 5 shows a perspective and partially sectional view of a buffering tank that is used for the apparatus of this invention for charging dry air or nitrogen gas.
Fig. 6 shows a perspective and partially sectional view of another buffering tank that is used for the apparatus of this invention for charging dry air or nitrogen gas.
Fig. 7 shows a perspective and partially sectional view of another buffering tank that is used for the apparatus of this invention for charging dry air or nitrogen gas.
Fig. 8 shows a plane view of the apparatus of this invention for removing static electricity, which uses the apparatus for charging dry air or nitrogen gas.
Fig. 9 shows a vertical and sectional view of the apparatus of this invention for removing static electricity, which uses the apparatus for charging dry air or nitrogen gas, and which is attached to the container for storing semiconductor wafers.
Fig. 10 shows a vertical and sectional view of the main part of the apparatus of this invention for removing static electricity, which uses the apparatus for charging dry air or nitrogen gas, and which uses a soft X-ray source as an ion generator used in a portion for providing ionized dry air or nitrogen gas.
Fig. 11 shows a schematic view to explain an device used for experiments for measuring a decay time when the ionized dry air passes through a filter.

### Preferred Embodiments of the Inventions

The present inventions relate to the following apparatuses:
- an apparatus for charging dry air or nitrogen gas into a container for storing semiconductor wafers without opening the lid of the container, to remove chemical gas and moisture from the container, and then to prevent the corrosion of the semiconductor wafers by preventing acid from being generated at the surfaces of the wafers, and
- an apparatus for removing static electricity from the surfaces of the wafers by using the above apparatus for charging ionized dry air or nitrogen gas into the container, to remove the charged static electricity from the wafers, and to remove the chemical gas and the moisture from the container, and, further, to prevent the corrosion of the wafers by preventing acid from being generated at the surfaces of the wafers.
   Below, embodiment 1, the apparatus for charging dry air or nitrogen gas, and embodiment 2, the apparatus for removing static electricity, are explained.

### Embodiment 1

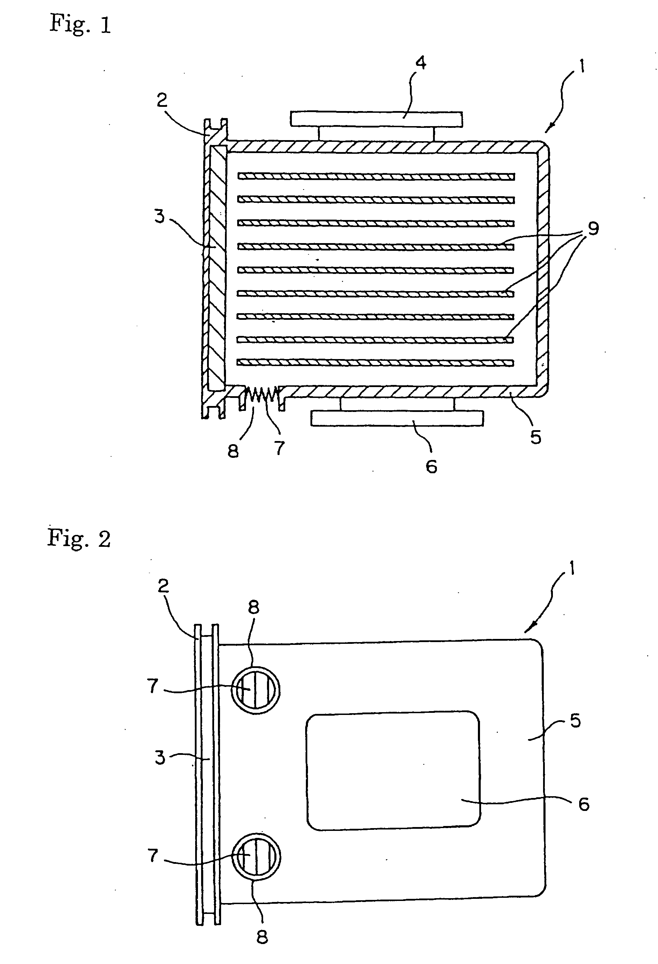

Embodiment 1 of the present inventions, the apparatus for charging dry air or nitrogen gas, is now explained in detail based on the figures. Fig. 1 shows a vertical and sectional view of the container for storing semiconductor wafers that is used for the present inventions. Fig. 2 shows a bottom plane view of the container. As shown in Figs. 1 and 2, the container 1 for storing semiconductor wafers comprises an openable and closable lid 3 that is disposed at the front of the container and the container 1 has a flange 2, a hook 4, for being suspended, disposed at its top plate, a leg 6 for being mounted on the table (not shown) disposed at its bottom plate 5, and a plurality of openings 8 having a PTFE filter 7.

The semiconductor wafers 9 are stored in the container 1. Except when the wafers 9 are being processed in an apparatus (not shown), since the wafers 9 are stored in the container 1, chemical gas is prevented from contacting the surfaces of the wafers 9.

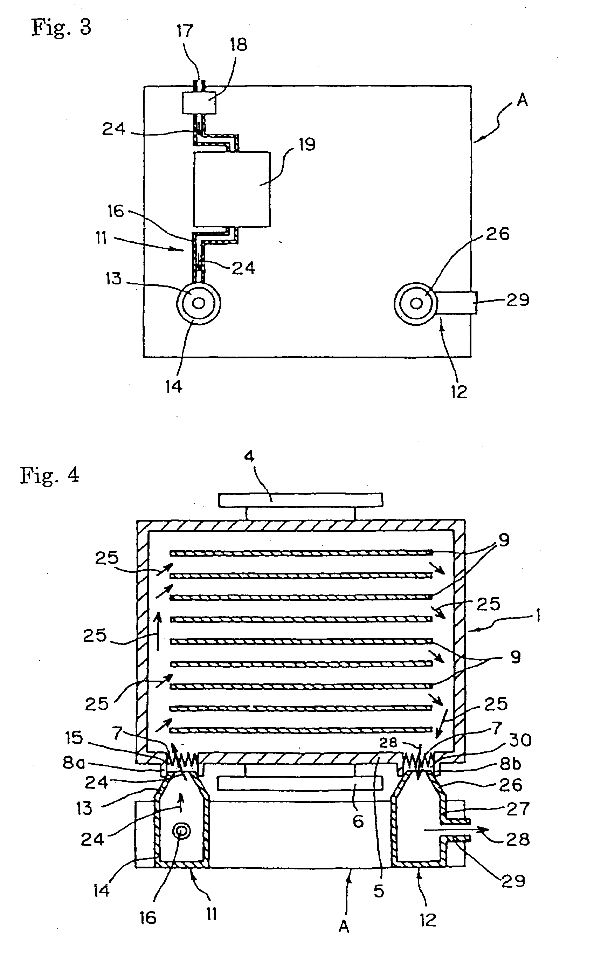

Fig. 3 shows a plane view of the apparatus for charging dry air or nitrogen gas into a container for storing semiconductor wafers. Fig. 4 shows a vertical and sectional view of the apparatus for charging dry air or nitrogen gas that is attached to the container 1 for storing the semiconductor wafers 9. As shown in Figs. 3 and 4, the apparatus A for charging dry air or nitrogen gas, which can remove chemical gas and moisture from the container 1, and then prevent the corrosion of the semiconductor wafers by preventing acid from being generated at the surfaces of the wafers, comprises:
a portion 11 for providing the dry air or nitrogen gas to charge the dry air or nitrogen gas into the container 1, and
a portion 12 for exhausting the used dry air or nitrogen gas to discharge the used dry air or nitrogen gas from the container 1 after removing chemical gas and moisture from the container 1, and then preventing acid from being generated at the surfaces of the wafers 9 by the dry air or nitrogen gas charged into the container 1.
The portion 11 for providing the dry air or nitrogen gas is connected to a hollow vessel 14 that has a nozzle 13 for providing it and is disposed at the side of the intake of the container 1.

The distal side of the nozzle 13 for providing the dry air or nitrogen gas has an approximately conical shape, so that the hollow vessel 14 disposed at the side of the intake of the container 1 can be hermetically fixed to the port 15 disposed at the upstream side of the PTFE filter 7 placed in the opening 8a disposed at the bottom plate 5 of the container 1. The hollow vessel 14 has a port at its sidewall to be connected to the downstream end of a pipe 16 for providing the dry air or nitrogen gas to the hollow vessel 14. An opening and closing valve 18 is disposed near a port 17 disposed at the upstream side of the pipe 16 for providing the dry air or nitrogen gas to the pipe 16. By adjusting the opening and closing valve 18, it is possible to control the flow rate of the dry air or nitrogen gas, and to start, or stop, providing the dry air or nitrogen gas to the hollow vessel 14.

Further, a buffering tank 19 is disposed at the pathway of the pipe 16 for providing the dry air or nitrogen gas between the opening and closing valve 18 and the hollow vessel 14. The dry air or nitrogen gas 24, which is provided from its source (not shown), is introduced into the buffering tank 19 through the port 17 and the pipe 16. Thus, the dry air or nitrogen gas 24 is introduced into the hollow vessel 14 at the averaged flow rate.

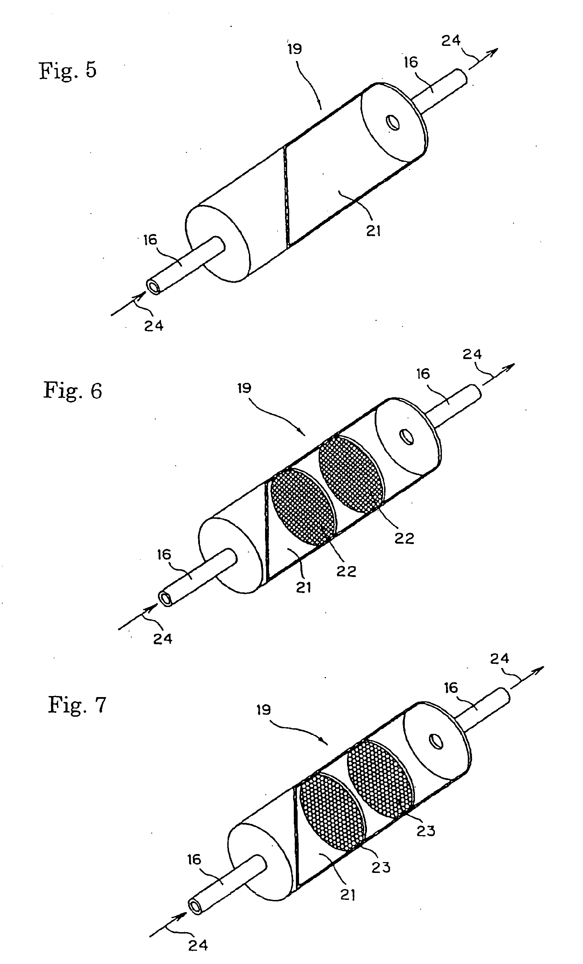

As the buffering tank 19, any type of buffering tank can be used. For example, as shown in Fig. 5, a type of buffering tank having only a hollow chamber 21, as shown in Fig. 6, a type of buffering tank having a hollow chamber 21 that includes a filter or a plurality of filters 22 disposed at predetermined intervals in the hollow chamber 21, or as shown in Fig. 7, a type of buffering tank having a hollow chamber 21 that includes a perforated plate or a plurality of perforated plates 23 disposed at predetermined intervals in the hollow chamber 21, can be used.

When the dry air or nitrogen gas 24 passes through the filters 22 or the perforated plates 23 of the buffering tank shown in Fig. 6 or 7, the pressure loss of the dry air or nitrogen gas 24 increasees in proportion to the flow rate of the dry air or nitrogen gas 24, as compared with the type of buffering tank having only a hollow chamber 21 as shown in Fig. 5. Thus, by using the characteristics of the filters 22, the perforated plates 23, and the buffering tank 19, when the dry air or nitrogen gas 24 is charged into the container 1 from the apparatus A, since the flow rate of the dry air or nitrogen gas 24 at the initial stage can be decreased, it is possible to prevent the dust that has accumulated at the bottom of the container 1 from being stirred up.

If the buffering tank 19, such as the type of buffering tank that has no filter nor perforated plate, as shown by Fig. 5, is used for the apparatus A, it would degrade the effect to lower the flow rate of the dry air or nitrogen gas 24 at the initial stage, and to prevent the dust that has accumulated at the bottom of the container 1 from being stirred up, compared with the types of buffering tanks that are shown by Fig. 6 or 7. However, the buffering tank 19 shown by Fig. 5 can be used for the present invention.

The dry air or nitrogen gas 24 that is charged into the hollow tank 14 passes through the PTFE filter 7 placed in the opening 8a disposed at the intake side of the container 1 to remove the dust from the dry air or nitrogen gas. Then, the dry air or nitrogen gas flows into the container 1. The dry air or nitrogen gas can remove the chemical gas and the moisture from the container 1, and then prevent the acid from being generated at the surfaces of the wafers 9.

In contrast, the portion 12 for exhausting the used dry air or nitrogen gas comprises the hollow vessel 27, which has the exhaust nozzle 26, and is disposed at the side of the exhaust port of the container 1, and has the exhaust port 29 disposed at its sidewall, wherein the exhaust port 29 discharges the used dry air or nitrogen gas 28 from the container 1 after the dry air or nitrogen gas that has been charged into the container 1 removes the chemical gas and the moisture from the container 1, and then prevents acid from being generated at the surfaces of the wafers 9. The distal side of the exhaust nozzle 26 has an approximately conical shape, so that the exhaust nozzle 26 can be hermetically fixed to the port 30 disposed at the downstream side of the PTFE filter 7 placed in the opening 8b disposed at the bottom plate 5 and at the exhaust port side of the container 1.

The used dry air or nitrogen gas 28, which has removed the chemical gas and the moisture from the container 1, and then prevented the acid from being generated at the surfaces of the wafers 9, is discharged from the exhaust port 29 to the outside of the container 1 after it flows into the hollow vessel 27 through the exhaust nozzle 26 and the PTFE filter 7 placed in the opening 8b disposed at the exhaust port side of the container 1.

Below the function of the apparatus A for charging dry air or nitrogen gas of Embodiment 1 of the present invention is explained in detail. The nozzle 13, for providing it, which is disposed at the hollow vessel 14 that is disposed at the portion 11 for providing the dry air or nitrogen gas, which portion constitutes a part of the apparatus A, is hermetically fixed to the port 15 disposed at the upstream side of the PTFE filter 7 placed in the opening 8a disposed at the bottom plate 5 and the intake side of the container 1. Then, the exhaust nozzle 26, disposed at the hollow vessel 27 that is disposed at the portion 12 for exhausting the used dry air or nitrogen gas, which portion constitutes another part of the apparatus A, is hermetically fixed to the port 30 disposed at the downstream side of the PTFE filter 7 placed in the opening 8b disposed at the bottom plate 5 and the exhaust side of the container 1.

After the apparatus A for charging dry air or nitrogen gas is connected to the container 1 for storing the semiconductor wafers 9, the dry air or nitrogen gas 24 is provided to the hollow vessel 14 disposed at the portion 11 for providing the dry air or nitrogen gas from its source (not shown) through the pipe 16 for providing the dry air or nitrogen gas. Since the dry air or nitrogen gas 24 that is provided to the hollow vessel 14 passes through the PTFE filter 7 placed in the opening 8a disposed at the intake side of the container 1, any dust in the dry air or nitrogen gas 24 can be removed. Then, the dry air or nitrogen gas 24 flows into the container 1, removes the chemical gas and the moisture in the container 1, and can prevent the corrosion of the semiconductor wafers 9 by preventing acid from being generated at the surfaces of the wafers 9.

After removing the chemical gas and the moisture in the container 1, and preventing the acid from being generated at the surfaces of the wafers 9, the used dry air and nitrogen gas 28 flow into the hollow vessel 27 through the PTFE filter 7 placed in the opening 8b disposed at the exhaust side of the container 1 and the exhaust nozzle 26. Then, the used dry air and nitrogen gas 28 is discharged outside the container 1 through the exhaust port 29.

### Embodiment 2

As Embodiment 2, an apparatus for removing static electricity using the above apparatus for charging dry air or nitrogen gas, is below explained based on the figures.

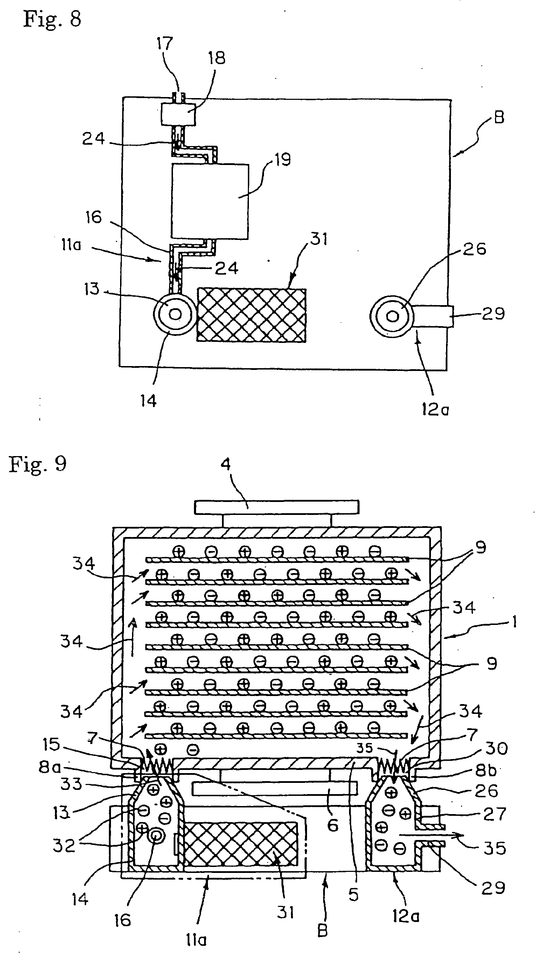

Fig. 8 shows a plane view of the apparatus for removing static electricity using the apparatus for charging dry air or nitrogen gas, of this invention. Fig. 9 shows a vertical and sectional view of the apparatus for removing static electricity that is attached to the container for storing the semiconductor wafers, which is shown by Figs. 1 and 2. As shown in Figs. 8 and 9, the apparatus B for removing static electricity, which is used for removing the static electricity charged on the wafers 9 in the container 1, comprises:
a portion 11a for providing ionized dry air or nitrogen gas to charge the ionized dry air or nitrogen gas into the container 1, which portion 11a uses a portion 11 for providing the dry air or nitrogen gas of the apparatus A,
a portion 12a for exhausting the used ionized dry air or nitrogen gas to discharge the used ionized dry air or nitrogen gas from the container 1 after removing chemical gas, moisture, and static electricity from the container 1, and then preventing acid from being generated at the surfaces of the wafers 9 by the ionized dry air or nitrogen gas charged into the container 1, which portion 12a uses a portion 12 for exhausting the used dry air or nitrogen gas of the apparatus A.
The apparatus B for removing static electricity further comprises an ion generator 31 for ionizing the dry air or nitrogen gas 24, which generator 31 is connected to the hollow vessel 14 that has the nozzle 13 for providing it and is disposed at the side of the intake of the container 1, and which vessel 14 constitutes a part of the apparatus A.
Below, since all other components of the apparatus B are the same as those of the apparatus A, the same denotations as those of apparatus A are used to explain the apparatus B.

The distal side of the nozzle 13 for providing the dry air or nitrogen gas has an approximately conical shape so that the hollow vessel 14 disposed at the side of the intake of the container 1 can be hermetically fixed to the port 15 disposed at the upstream side of the PTFE filter 7, which filter is placed in the opening 8a disposed at the bottom plate 5 of the container 1. The hollow vessel 14 has a port at its sidewall to be connected to the downstream end of a pipe 16 for providing the dry air or nitrogen gas 24 to the hollow vessel 14. An opening and closing valve 18 is disposed near a port 17 disposed at the upstream side of the pipe 16 for providing the dry air or nitrogen gas 24 to the pipe 16. By adjusting the opening and closing valve 18, it is possible to control the flow rate of the dry air or nitrogen gas 24, and to start or stop providing the dry air or nitrogen gas 24 to the hollow vessel 14.

Further, a buffering tank 19 is disposed at the pathway of the pipe 16 for providing the dry air or nitrogen gas between the opening and closing valve 18 and the hollow vessel 14. The dry air or nitrogen gas 24, which is provided from its source (not shown), is introduced into the buffering tank 19 through the port 17 and the pipe 16. Thus, the dry air or nitrogen gas 24 is introduced into the hollow vessel 14 at the averaged flow rate.

As the buffering tank 19, any type of buffering tank can be used. For example, as shown in Fig. 5, a type of buffering tank having only a hollow chamber 21, as shown in Fig. 6, a type of buffering tank having a hollow chamber 21 that includes a filter or a plurality of filters 22 disposed at predetermined intervals in the hollow chamber 21, or as shown in Fig. 7, a type of buffering tank having a hollow chamber 21 that includes a perforated plate or a plurality of perforated plates 23 disposed at predetermined intervals in the hollow chamber 21, can be used.

When the dry air or nitrogen gas 24 passes through the filters 22 or the perforated plates 23 of the buffering tank shown in Fig. 6 or 7, the pressure loss of the dry air or nitrogen gas 24 increases in proportion to the flow rate of the dry air or nitrogen gas 24, as compared with the type of buffering tank having only a hollow chamber 21 as shown in Fig. 5. Thus, by using the characteristics of the filters 22, the perforated plates 23, and the buffering tank 19, when the ionized dry air or nitrogen gas 24 is charged into the container 1 from the apparatus B, since the flow rate of the dry air or nitrogen gas 24 at the initial stage can be suppressed, it is possible to prevent the dust that has accumulated at the bottom of the container 1 from being stirred up.

If the buffering tank 19, such as the type of buffering tank that has no filter nor perforated plate, as shown by Fig. 5, is used for the apparatus A, it would degrade the effect to decrease the flow rate of the dry air or nitrogen gas 24 at the initial stage, and to prevent the dust that has accumulated at the bottom of the container 1 from being stirred up, as compared with the types of buffering tanks that are shown by Fig. 6 and 7. However, the buffering tank 19 shown by Fig. 5 can be used for the present invention.

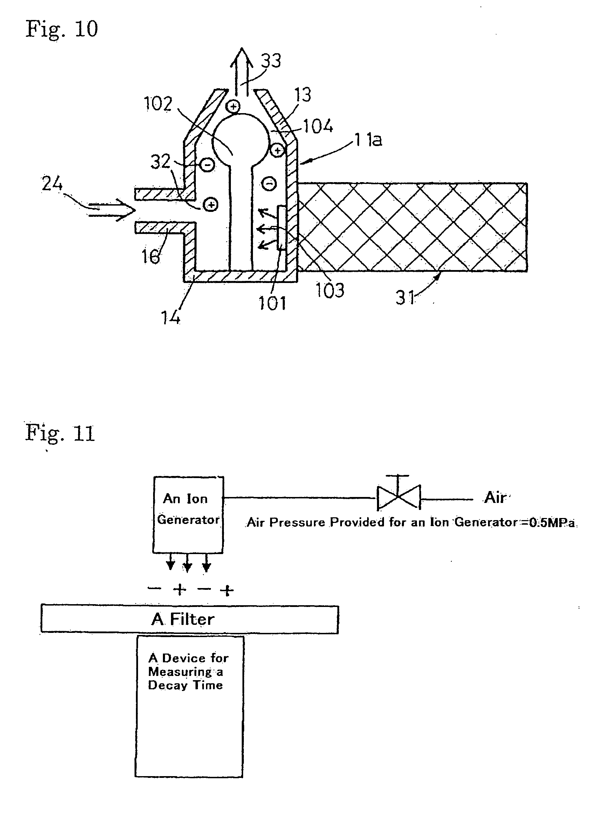

Fig. 10 shows the portion 11a for providing ionized dry air or nitrogen gas that uses a soft X-ray source, for example, as the ion generator 31 for ionizing the dry air or nitrogen gas 24 provided for the hollow vessel 14. The hollow vessel 14 has an obstacle 102 for blocking the soft X-rays, which obstacle forms a clearance 104 between the nozzle 13 for providing the dry air or nitrogen gas of the hollow vessel 14 and the obstacle 102, so that the soft X-rays 103 irradiated into the hollow vessel 14 through a window 101 from the soft X-ray source (the ion generator 31) do not go straight ahead. The dry air or nitrogen gas 24 that is provided to the hollow vessel 14 through the pipe 16 is ionized by the soft X-rays 103 irradiated into the hollow vessel 14 through a window 101. Consequently, plus (+) ions and minus (-) ions 32 are generated in the hollow vessel 14, and are charged into the container 1 for storing the wafers as the ionized dry air or nitrogen gas 32 through the clearance 104, between the nozzle 13 for providing it, of the hollow vessel 14 and the obstacle 102.

The dry air or nitrogen gas 24 that is charged into the hollow tank 14 is ionized by the soft X-rays 103, and becomes the ionized dry air or nitrogen gas 33. The dust in the ionized dry air or nitrogen gas 33 is removed by the PTFE filter 7 placed in the opening 8a disposed at the intake side of the container 1, and then flows into the container 1 as the flow 34 of the ionized dry air or nitrogen gas. In the container 1, the ionized dry air or nitrogen gas can remove the chemical gas and the moisture from the container 1, can also remove the static electricity from the surfaces of the wafers 9, and can then prevent acid from being generated at the surfaces of the wafers 9. By using the PTFE filter, the dust in the ionized dry air or nitrogen gas can be removed, but the ions in it can be maintained. Then, the dry air or nitrogen gas 24 flows into the container 1 as the flow 34 of the ionized dry air or nitrogen gas.

In contrast, the portion 12a for exhausting the used ionized dry air or nitrogen gas comprises the hollow vessel 27 that has the exhaust nozzle 26, which vessel 27 is disposed at the side of the exhaust port of the container 1, and which vessel 27 has the exhaust port 29 disposed at its sidewall,
wherein the exhaust port 29 discharges the used ionized dry air or nitrogen gas 35 from the container 1 after the ionized dry air or nitrogen gas charged into the container 1 removes the chemical gas and the moisture from the container 1, also removes the static electricity from the surfaces of the wafers 9, and then prevents acid from being generated at the surfaces of the wafers 9.
The distal side of the exhaust nozzle 26 has an approximately conical shape so that the exhaust nozzle 26 can be hermetically fixed to the port 30 disposed at the downstream side of the PTFE filter 7 placed in the opening 8b disposed at the bottom plate 5 and at the exhaust side of the container 1.

The used ionized dry air or nitrogen gas 35, which has removed the chemical gas and the moisture from the container 1, also removed the static electricity from the surfaces of the wafers 9, and then prevented any acid from being generated at the surfaces of the wafers 9, is discharged from the exhaust port 29 outside the container 1 after it flows into the hollow vessel 27 through the exhaust nozzle 26 and the PTFE filter 7 placed in the opening 8b disposed at the exhaust side of the container 1. Each of the openings 8 disposed at the intake side and the exhaust side of the container 1 has the filter 7 so as to be used as an opening for both the intake and exhaust.

Below, the function of the apparatus B of Embodiment 2 of the present invention for removing the static electricity is explained in detail. The nozzle 13 for providing the ionized dry air or nitrogen gas, disposed at the hollow vessel 14 that is disposed at the portion 11a for providing the ionized dry air or nitrogen gas, which portion constitutes a part of the apparatus B, is hermetically fixed to the port 15 disposed at the upstream side of the PTFE filter 7 placed in the opening 8a disposed at the bottom plate 5 and the intake side of the container 1. The exhaust nozzle 26, disposed at the hollow vessel 27 that is disposed at the portion 12a for exhausting the used ionized dry air or nitrogen gas, which portion constitutes another part of the apparatus B, is hermetically fixed to the port 30 disposed at the downstream side of the PTFE filter 7 placed in the opening 8b disposed at the bottom plate 5 and the exhaust side of the container 1.

After the apparatus B for removing static electricity is connected to the container 1 for storing the semiconductor wafers 9, the ionized dry air or nitrogen gas 24 is provided to the hollow vessel 14 disposed at the portion 11a for providing the ionized dry air or nitrogen gas from its source (not shown) through the pipe 16 for providing the dry air or nitrogen gas. When the ion generator 31 provides the hollow vessel 14 with the soft X-rays, the dry air or nitrogen gas in the hollow vessel 14 is ionized by the soft X-rays and becomes the ionized dry air or nitrogen gas 33. Since the ionized dry air or nitrogen gas 33 in the hollow vessel 14 passes through the PTFE filter 7 placed in the opening 8a disposed at the intake side of the container 1, the dust in the ionized dry air or nitrogen gas can be removed, but the ions in it can be maintained. Then, the ionized dry air or nitrogen gas 33 flows into the container 1, removes the chemical gas and the moisture in the container 1, also removes the static electricity from the surfaces of the wafers 9, and can prevent acid from being generated at the surfaces of the wafers 9.

After removing the chemical gas and the moisture in the container 1, removing the static electricity from the surfaces of the wafers 9, and preventing the acid from being generated at the surfaces of the wafers 9, the used dry air and nitrogen gas 35 flow into the hollow vessel 27 through the PTFE filter 7 placed in the opening 8b disposed at the exhaust side of the container 1 and the exhaust nozzle 26. Then, the used dry air and nitrogen gas 35 is discharged outside the container 1 through the exhaust port 29.

As explained in the above paragraphs, the PTFE filters 7 are provided for the bottom plate 5 of the container 1 for storing semiconductor wafers so as to prevent dust from infiltrating the container 1 and to maintain the ions in the dry air or nitrogen gas. The PTFE filter 7 is comprised of a porous film that has very fine pores and is made from an extended polytetraphenolethylene film, which type of film is usually used for a filter. Namely, the PTFE filter is not a glass-fiber filter using glass fibers as one of the materials of the filter. If the glass-fiber filter were to be used for the filter of the present invention, then when the ionized dry air or nitrogen gas would pass through the glass-fiber filter, the number of ions in the ionized dry air or nitrogen gas would be reduced by the filter. Thus, a glass-fiber filter cannot be used for the present invention.

In contrast, the PTFE filter used for the present invention can charge the ionized dry air or nitrogen gas 33 into the container 1 for storing the semiconductor wafers without notably reducing the number of ions in the ionized dry air or nitrogen gas 33. To verify this effect, the following experiments using a device for experiments as shown in Fig. 11 were conducted.

For the experiments, decay time, which is defined as an ordinary physical property, is used to evaluate the reduction of static electricity. The decay time is measured by a device for measuring it, while the apparatus for removing static electricity is operated under these conditions:
a) after not passing through any filter,
b) after passing through the PTFE filter, and
c) after passing through the glass-fiber filter.

Below, the results of the experiments are explained.

The measurements of the decay time at an air pressure of 0.5 MPa that is provided for the apparatus for removing static electricity are as follows:
a) after not passing through any filter:
   The decay time: 0.4 sec (plus charge)
   The decay time: 0.5 sec (minus charge)
b) after passing through the PTFE filter:
   The decay time: 1.9 sec (plus charge)
   The decay time: 4.7 sec (minus charge)
c) after passing through the glass-fiber filter:
   The decay time: ∞ sec (plus charge)
   The decay time: ∞ sec (minus charge)
From the results of the experiments, it is seen that a) at the barrier-free condition, that is, no filter is used in the passage of the ionized dry air, the static electricity can be removed within a short time, and b) even though the PTFE filter was used in the passage of the ionized dry air, which filter constitutes a kind of barrier, although the efficiency for removing the static electricity was reduced to some degree, it was verified that the static electricity can be removed. Further, c) though the glass-fiber filter was used in the passage of the ionized dry air, which filter also constitutes a kind of barrier, it was verified that the static electricity cannot be removed. Namely, it became clear that the ions contained in the ionized dry air or nitrogen gas are lost when it passes through the glass-fiber filter. From the results of the experiments, further, it became clear that to some degree, although the PTFE filter reduces the number of ions in the ionized dry air or nitrogen gas 33, it can provide the ionized dry air or nitrogen gas 33 having enough ions to the container 1 for storing semiconductor wafers.

When the ionized dry air or nitrogen gas 33 is provided to the container 1, since the pressure in the container 1 is low at the initial stage, the flow rate of the ionized dry air or nitrogen gas 33 that is charged into the container 1 is high. Thus, it is possible that the dust that has accumulated at the bottom of the container 1 will be stirred up, and then will be attached to the surfaces of the wafers 9. Over time, since the pressure in the container 1 increases, the flow rate of the ionized dry air or nitrogen gas 33 is reduced. Thus, the dust is not stirred up.

Based on the effect explained in the above paragraphs, a buffering tank 19 is installed on the pathway for providing the dry air or nitrogen gas 24 of the apparatus B for removing static electricity, that is, on the pipe 16 for providing the dry air or nitrogen gas between the opening and closing valve 18 and the hollow vessel 14. Consequently, the flow rate of the dry air or nitrogen gas 24 that is charged into the hollow vessel 14 is averaged. The dry air or nitrogen gas 24 that has its flow rate averaged then flows into the hollow vessel 14 and is ionized. The ionized dry air or nitrogen gas 33 is provided at a slow speed to the container 1 as a flow 34 of the ionized dry air or nitrogen gas. Thus, the dust that has accumulated at the bottom of the container 1 is not stirred up.
The effects of the buffering tank shown in Figs. 5-7 are the same as those previously explained. Thus, a detailed explanation of the buffering tank is omitted.

## Claims

1. An apparatus for charging dry air or nitrogen gas into a container for storing semiconductor wafers, wherein the container comprises a plurality of openings disposed at the bottom plate of the container, and wherein the apparatus for charging dry air or nitrogen gas is connected to the opening for an intake and to the opening for an exhaust, the apparatus comprising:
PTFE filters disposed at the plurality of openings,
a portion for providing the dry air or nitrogen gas to charge the dry air or nitrogen gas into the container, and
a portion for exhausting the used dry air or nitrogen gas to discharge the used dry air or nitrogen gas from the container after removing chemical gas and moisture from the container, and then preventing acid from being generated at the surfaces of the wafers by the dry air or nitrogen gas charged into the container,
wherein the portion for providing the dry air or nitrogen gas is connected to a hollow vessel that has a nozzle for providing it and is disposed at the side of the intake of the container, and the nozzle for providing it is hermetically fixed to the opening for the intake,
wherein the portion for exhausting the used dry air or nitrogen gas is connected to a hollow vessel that has an exhaust nozzle and an exhaust port for discharging the used dry air or nitrogen gas and is disposed at the side of the exhaust port of the container, and the exhaust nozzle is hermetically fixed to the opening for the exhaust,
wherein the dry air or nitrogen gas that is provided to the hollow vessel disposed at the side of the intake of the container is filtered by removing dust by means of the PTFE filter and flows into the container, and then removes chemical gas and moisture from the container, and prevents acid from being generated at the surfaces of the wafers, and
wherein the used dry air or nitrogen gas is discharged into the hollow vessel disposed at the side of the exhaust through the PTFE filter disposed at the opening for the exhaust, and then is exhausted through the exhaust port of the hollow vessel disposed at the side of the exhaust.

2. The apparatus for charging dry air or nitrogen gas of claim 1, further comprising a buffering tank disposed on the pathway for providing the dry air or nitrogen gas of the portion for providing the dry air or nitrogen gas.

3. The apparatus for charging dry air or nitrogen gas of claim 2,
wherein the buffering tank of the apparatus for charging dry air or nitrogen gas comprises a hollow vessel.

4. The apparatus for charging dry air or nitrogen gas of claim 2,
wherein the buffering tank of the apparatus for charging dry air or nitrogen gas further comprises a filter or a plurality of filters disposed at predetermined intervals in the buffering tank.

5. The apparatus for charging dry air or nitrogen gas of claim 2,
wherein the buffering tank of the apparatus for charging dry air or nitrogen gas further comprises a perforated plate or a plurality of perforated plates disposed at predetermined intervals in the buffering tank.

6. An apparatus for removing static electricity by using the apparatus for charging dry air or nitrogen gas into a container for storing semiconductor wafers, wherein the container comprises a plurality of openings disposed at the bottom plate of the container, and wherein the apparatus for charging dry air or nitrogen gas is connected to the opening for an intake and to the opening for an exhaust, the apparatus for removing static electricity comprising:
PTFE filters disposed at the plurality of openings, a portion for providing the ionized dry air or nitrogen gas to charge the ionized dry air or nitrogen gas into the container, and
a portion for exhausting the used ionized dry air or nitrogen gas to discharge the used ionized dry air or nitrogen gas from the container after removing chemical gas, moisture, and static electricity from the container, and then preventing acid from being generated at the surfaces of the wafers by the ionized dry air or nitrogen gas charged into the container,
wherein the portion for providing the dry ionized air or nitrogen gas is connected to a hollow vessel that has a nozzle for providing it and is disposed at the side of the intake of the container, and the nozzle for providing it is hermetically fixed to the opening for the intake, the hollow vessel being further connected to an ion generator that ionizes the dry air or nitrogen gas,
wherein the portion for exhausting the used ionized dry air or nitrogen gas is connected to a hollow vessel that has an exhaust nozzle and an exhaust port for discharging the used ionized dry air or nitrogen gas and is disposed at the side of the exhaust port of the container, and the exhaust nozzle is hermetically fixed to the opening for the exhaust,
wherein the dry air or nitrogen gas that is provided to the hollow vessel disposed at the side of the intake of the container becomes ionized dry air or nitrogen by ionization, and is filtered by removing dust by means of the PTFE filter while the ions are maintained and flow into the container, and then removes the chemical gas, the moisture, and the static electricity from the container, and prevents acid from being generated at the surfaces of the wafers, and
wherein the used ionized dry air or nitrogen gas is discharged into the hollow vessel disposed at the side of the exhaust port through the PTFE filter disposed at the opening for the exhaust, and then is exhausted through the exhaust port of the hollow vessel disposed at the side of the exhaust port.

7. The apparatus for removing the static electricity of claim 6, further comprising a buffering tank disposed on the pathway for providing the ionized dry air or nitrogen gas of the portion for providing the ionized dry air or nitrogen gas.

8. The apparatus for removing static electricity of claim 7, wherein the buffering tank of the apparatus for removing static electricity comprises a hollow vessel.

9. The apparatus for charging dry air or nitrogen gas of claim 7,
wherein the buffering tank of the apparatus for removing static electricity further comprises a filter or a plurality of filters disposed at predetermined intervals in the hollow vessel.

10. The apparatus for charging dry air or nitrogen gas of claim 7,
wherein the buffering tank of the apparatus for removing static electricity further comprises a perforated plate or a plurality of perforated plates disposed at predetermined intervals in the hollow vessel.
